(19)

Europäisches
Patentamt
European
Patent Office
Office européen
des brevets

(11) **EP 4 175 110 A1**

(12) **EUROPEAN PATENT APPLICATION**
published in accordance with Art. 153(4) EPC

(43) Date of publication:
**03.05.2023 Bulletin 2023/18**

(21) Application number: **21832968.8**

(22) Date of filing: **10.06.2021**

(51) International Patent Classification (IPC):
***H02J 7/00*** (2006.01)

(86) International application number:
**PCT/CN2021/099435**

(87) International publication number:
**WO 2022/001617 (06.01.2022 Gazette 2022/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.06.2020 CN 202010599455**

(71) Applicant: **ZTE Corporation
Shenzhen, Guangdong 518057 (CN)**

(72) Inventor: **ZHANG, Qingli
Shenzhen, Guangdong 518057 (CN)**

(74) Representative: **Novagraaf Technologies
Bâtiment O2
2, rue Sarah Bernhardt
CS90017
92665 Asnières-sur-Seine Cedex (FR)**

(54) **CHARGING METHOD, TERMINAL AND STORAGE MEDIUM**

(57)     Embodiments of the invention relate to the field of charging, and provided are a charging method, a terminal and a storage medium. The charging method includes: obtaining an equivalent impedance between a charger and a charging chip of a terminal and a battery impedance of a battery in the terminal; obtaining a charging power according to the battery impedance, the equivalent impedance and a target power, where the target power includes a maximum power supported by the battery or a maximum power supported by the charger; and controlling the charger to charge the battery according to the charging power.

Fig. 1

## Description

### Technical Field

Embodiments of the invention relate to the field of charging, in particular to a charging method, a terminal and a storage medium.

### Background

The fast charging technology has been increasingly widely used in mobile phones, Bluetooth headsets, etc. by increasing output voltages or output currents of chargers required to adapted to the terminals.

In the process of implementing embodiments of the invention, the inventor found that in the case that a third-party charger is used to charge the terminal, if the maximum power supported by the third-party charger is greater than a power set by the terminal, the terminal will charge batteries according to the power set by itself, resulting in a failure to exploit the power advantage of the charger; and if the maximum power supported by the third-party charger is less than the power set by the terminal, the charger will be hung up. For example, if users use a low power of 13.5 W, and the power of a standard charger of the terminal is 18 W, the charger will be deactivated and cannot perform charging normally.

### Summary

Embodiments of the invention aim at providing a charging method, a terminal and a storage medium, such that the terminal may be compatible with a third-party charger and charging efficiency of the terminal may be improved.

The embodiment of the invention provides a charging method. The charging method of the invention includes: obtaining an equivalent impedance between a charger and a charging chip of a terminal and a battery impedance of a battery in the terminal; obtaining a charging power according to the battery impedance, the equivalent impedance and a target power, where the target power includes a maximum power supported by the battery or a maximum power supported by the charger; and controlling the charger to charge the battery according to the charging power.

The embodiment of the invention further provides a terminal. The terminal includes at least one processor; and, a memory in communication connection with the at least one processor, where the memory stores an instruction executable by the at least one processor, and when executed by the at least one processor, the instruction causes the at least one processor to execute the charging method above.

The embodiment of the invention further provides a computer-readable storage medium. The computer-readable storage medium stores a computer program, where the computer program implements the charging method above when executed by a processor.

### Brief Description of the Drawings

One or more embodiments are exemplarily described with drawings in corresponding accompanying drawings, and such exemplary description does not constitute limitation on the embodiments.

Fig. 1 is a flowchart of a charging method according to a first embodiment of the invention;

Fig. 2 is a flowchart of a charging method according to a second embodiment of the invention;

Fig. 3 is a schematic diagram for specific implementation of a step of obtaining a maximum power supported by a charger in a charging method according to a third embodiment of the invention;

Fig. 4 is a schematic diagram for specific implementation of a step of adjusting an output current of the charger in the charging method in Fig. 3; and

Fig. 5 is a structural block diagram of a terminal according to a fourth embodiment of the invention.

### Detailed Description of the Embodiments

In order to make objectives, technical solutions and advantages of embodiments of the invention more clear, embodiments of the invention will be described in detail below with reference to accompanying drawings. However, those of ordinary skill in the art can understand that in each embodiment of the invention, many technical details have been put forward in order to make readers better understand the invention. However, even without these technical details and various changes and modifications based on the embodiments below, technical solutions to be protected required by the invention can be implemented. The following embodiments are divided for the convenience of description, and should not constitute any limitation to the specific implementation of the invention. Each embodiment can be combined with one another by reference on the premise of no contradiction.

The inventor finds that current fast charging technology usually adopts a charging chip containing a charge pump, the charge pump features high charging conversion efficiency, but is difficult to control in powers, resulting in incompatibility with a low power charger. Therefore, a terminal using the fast charging technology is usually equipped with a matched charger, such that a battery in the terminal may be charged while safety of the charger and the terminal are guaranteed. Maximum powers achievable by the rapid charging technology usually include 100 W, 28 W, 25 W, 20 W, 22.5 W, 18 W, etc. A maximum power of ordinary charging technology may be 13.5 W, etc. Because a charging speed is related to the power, the higher the power is, the shorter full charge time is. For example, it takes 4-5 h to charge a mobile phone by ordinary charging technology, and takes 1 h with 28 W power in the case of the same battery capacity, showing a charging speed higher than that with an ordinary power. At present, a charging power may be increased by increasing a voltage of the charge, an output current of the charger and a combination thereof at the same time. However, in an actual application, a fixed current is always used in fast charging technology that supports dynamic adjustment of the voltage. There are security problems when a user uses a third-party charger to charge the terminal. For example, the terminal is equipped with a 18 W charger as standard. If the terminal is set to be charged according to 18 W, the user may only use 18 W power when using a higher-power charger, such as a 27 W charger, which may not give full play to a capacity of the charger. However, if the user uses a lower-power charger, such as a 13. 5 W charger, the charger will be deactivated and may not perform charging normally.

The following embodiments may solve the above problems.

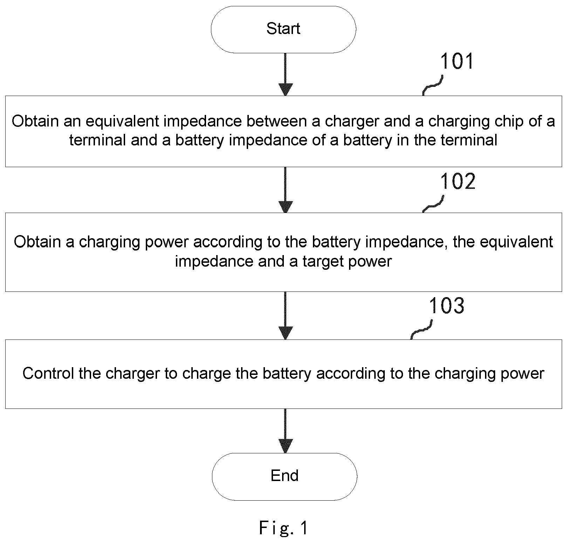

A first embodiment of the invention relates to a charging method with a flow shown in Fig. 1.

Step 101: an equivalent impedance between a charger and a charging chip of a terminal and a battery impedance of a battery in the terminal are obtained.

Step 102: a charging power is obtained according to the battery impedance, the equivalent impedance and a target power, where the target power includes a maximum power supported by the battery or a maximum power supported by the charger.

Step 103: the charger is controlled to charge the battery according to the charging power.

Compared with the prior art, in the embodiment of the invention, the charging power is obtained based on the equivalent impedance between the charger and the charging chip of the terminal, the battery impedance and the target power of the battery in the terminal, and the battery is charged according to the charging power. When chargers with different powers are adopted, equivalent impedances and target powers are different accordingly, such that obtained charging powers correspond to the chargers. Because the charging powers correspond to the chargers, when the power of the charger is greater than the power set by the terminal, the problem that the power of the charger may not be fully utilized may be avoided. When the power of the charger is less than the power set by the terminal, the phenomenon that the charger is deactivated may be avoided, thereby improving compatibility between the terminal and the charger is improved, and charging efficiency.

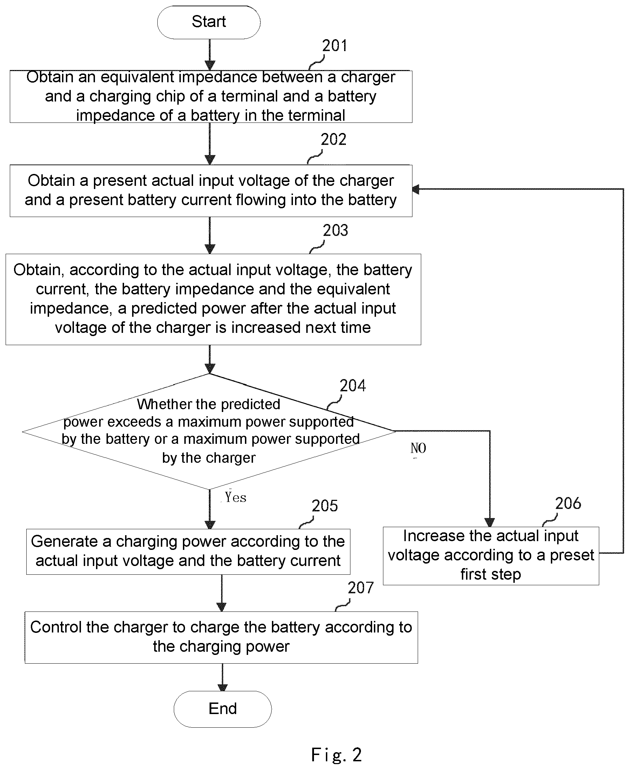

A second embodiment of the invention relates to a charging method with a flow shown in Fig. 2.

The charging method in this example may be applied to a terminal having a charging chip connected to a battery in the terminal. The charging chip may include a charge pump and a switching charging module, and the charge pump is connected to the switching charging module in parallel and then connected to the battery. After detecting that the charger is connected to the charging chip, the terminal may identify whether the charger supports the fast charging technology. If the charger does not support the fast charging technology, it will directly end the whole flow. If the charger supports the fast charging technology, the subsequent steps will be executed. There are many ways to identify the charger, for example, by detecting a voltage of D+ pin of the charger and a short circuit.

In addition, by adjusting a voltage of the charge pump, the battery current flowing into the battery may be adjusted, while the switching charging module may accurately adjust the battery current. However, charging conversion efficiency of the switching charging module is lower than that of the charge pump, and when the battery is charged, the charge pump is used for charging conversion.

It may be understood that in order to guarantee that the battery is charged with the maximum power, the maximum current flowing into the battery may be set as a maximum current supported by the battery.

Step 201: an equivalent impedance between a charger and a charging chip of a terminal and a battery impedance of a battery in the terminal are obtained.

In one example, the process of obtaining the equivalent impedance between the charger and the charging chip of the terminal may be as follows: a first output current difference is obtained according to a first output current output by the charger at a first moment and a first input voltage of the charger at the first moment; a first input voltage difference is obtained according to a second output current output by the charger at a second moment and a second input voltage of the charger at the second moment; and the equivalent impedance is obtained according to the ratio between the first input voltage difference and the first output current difference.

Specifically, in this example, the input voltage of the charger refers to a voltage input by the charger to the charging chip. When the input voltage of the charger is constant, an actually collected input voltage of the charger may decrease when the current increases due to an resistance between the charger and the charging chip. Based on this, the first output current output by the charger is set at the first moment and the first input voltage of the charger is collected at the first moment, the second output current output by the charger is set at the second moment and the second input voltage of the charger is collected at the second moment. Since the equivalent impedance also consumes electric energy, the equivalent impedance may be obtained according to a variation of the input voltage and a variation of the output current of the charger between the first moment and the second moment. For example, the first output current A1 is set at the first moment, and the collected first input voltage is V1. The second output current A2 is set at the second moment, and the collected second input voltage is V2. Then the equivalent impedance $R_{line}$= (V1-V2)/(A2-A1), where the second output current A2 at the second moment is larger than the first output current A1, and the current in the charging chip is controlled by the switching charging module.

In another example, it is also possible to compute the equivalent impedance many times. Specifically, an average of multiple equivalent impedances, and the computed average is taken as a new equivalent impedance, for example, a first equivalent impedance is computed as R1, a second equivalent impedance is computed as R2, and a third equivalent impedance is computed as R3, and a new equivalent impedance is updated to $R_{line}$= (R1+ R2+ R3) /3.

It is worth mentioning that by computing the equivalent impedance many times, the average of the multiple equivalent impedances is obtained, and the computed average is taken as the new equivalent impedance, such that accuracy of the obtained equivalent impedance is improved.

In one example, the process of obtaining the battery impedance of the battery in the terminal may be as follows: under an initial voltage of the charger, s measured current flowing into the battery is obtained; the initial voltage is increased according to a preset second step to obtain an adjusted measured current; and according to the measured current, the adjusted measured current and the equivalent impedance, the battery impedance is obtained.

Specifically, by turning on the charge pump, the initial voltage may be set to V0=2*Vbatt+$\triangle$V. $\triangle$V is set per specification parameters of the charging chip. For example, $\triangle$V may be 1 V. Under the initial voltage, the current measured current flowing into the battery is denoted as Ipre. The initial voltage is increased according to the preset second step, the second step may be denoted as Vdelta, for example, the second step is 200 mA. After adjustment, the voltage of the charger is V0+Vdelta. Under the condition that the voltage of the charger is V0+Vdelta, the measured current Inowo flowing into the battery is recorded, and the battery impedance may be computed according to formula (1):

$$(Vdelta- ((Inow-Ipre) /2) *R\ line) /2 = (Inow-Ipre) *Rbatt \qquad (1);$$

Formula (1) is varied to obtain formula (2);

$$Rbatt=Vdelta/ (2* (Inow-Ipre)) -Rline/4 \qquad (2);$$

where Rline in formula (1) and formula (2) is the equivalent impedance, Rbatt is the battery impedance, Vdelta is the preset second step, Ipre is the measured current flowing into the battery under the initial voltage of the charger, Inow is the measured current flowing into the battery after the initial voltage is increased according to the preset second step.

It may be understood that, similar to the equivalent impedance, different initial voltages may be set to obtain a plurality of Rbatts, and the average of the plurality of Rbatts may be computed, and the average of the plurality of Rbatts may be taken as the new battery impedance. The accuracy of the obtained battery impedance is improved.

Step 202: a present actual input voltage of the charger and a present battery current flowing into the battery are obtained.

Specifically, this step may be performed after obtaining the battery impedance and the equivalent impedance.

Step 203: according to the actual input voltage, the battery current, the battery impedance and the equivalent impedance, a predicted power is obtained after the actual input voltage of the charger is increased next time.

In one example, according to the first step, the battery current, the battery impedance and the equivalent impedance, the predicted battery current is obtained after the actual input voltage of the charger is increased next time. A product of the actual input voltage and the predicted battery current is taken as the predicted power.

Specifically, the charger increases the input voltage of the charger according to the preset first step. In this example, the first step and the second step may be the same, for example, the first step and the second step may be 200 mV. The predicted battery current may be obtained with formula (3):

$$Inew = Inow + Vdelta / (2* (Rbatt + Rline/4)) \qquad (3);$$

where Inew is the predicted battery current, Inow is the current battery current, Vdelta is the first step, Rbatt is the battery impedance, and Rline is the equivalent impedance. In addition, in this example, the ratio between the input voltage and output voltage of the charge pump is 2:1, the ratio between the input voltage and the output voltage of the charge pump may be other values, and formula (3) may be varied according to the ratio between the input voltage and the output voltage of the charge pump.

After the predicted battery current is obtained, the product of the actual input voltage and the predicted battery current is taken as the predicted power.

It should be noted that the terminal may initiate a boosting request to the charger, and the boosting request may be a designated pulse signal. After receiving the pulse signal, the charger may pull up D+ pin of the charger, and the actual input voltage of the charger may be increased according to the preset first step, for example, the first step may be 200 mV. If the D+ pin is pulled up 20 times continuously, the input voltage of the charger may be increased from initial 5 V to 9 V.

It is worth mentioning that, in this example, before the product between the actual input voltage and the predicted battery current is taken as the predicted power, whether the predicted battery current is smaller than the maximum current supported by the battery may be determined. If so, step 204 is executed; otherwise, the terminal does not send a boosting request to the charger, and the product of the actual input voltage and the current battery current is taken as the charging power.

By determining the predicted battery current, if the predicted battery current exceeds the maximum current of the battery, the charging power may be determined, thereby improving efficiency of obtaining the charging power.

Step 204: whether the predicted power exceeds a maximum power supported by the battery or a maximum power supported by the charger is determined, if so, step 205 is executed; otherwise, step 206 is executed.

Step 205: a charging power is generated according to the actual input voltage and the battery current.

Specifically, if the current power exceeds the maximum power supported by the battery or the maximum power supported by the charger, it indicates that the current power is the maximum power supported by the battery or the maximum power supported by the charger, and the product of the actual input voltage and the battery current is taken as the charging power.

Step 206: the actual input voltage is increased according to the preset first step, and step 202 is executed continuously until the obtained predicted power exceeds the maximum power supported by the battery or the maximum power supported by the charger.

When the predicted power does not exceed the maximum power supported by the battery and exceeds the maximum power supported by the charger, it indicates that the actual input voltage of the charger may be continuously increased.

Step 207: the charger is controlled to charge the battery according to the charging power.

It should be noted that in this example, steps 202-206 are specific description of obtaining the charging power according to the battery impedance, the equivalent impedance and the target power.

Compared with the prior art, in the embodiment of the invention, the charging power is obtained based on the equivalent impedance between the charger and the charging chip of the terminal, the battery impedance and the target power of the battery in the terminal, and the battery is charged according to the charging power. When chargers with different powers are adopted, equivalent impedances and target powers are different accordingly, such that obtained charging powers correspond to the chargers. Because the charging powers correspond to the chargers, when the power of the charger is greater than the power set by the terminal, the problem that the power of the charger may not be fully utilized may be avoided. When the power of the charger is less than the power set by the terminal, the phenomenon that the charger is deactivated may be avoided, thereby improving compatibility between the terminal and the charger is improved, and charging efficiency.

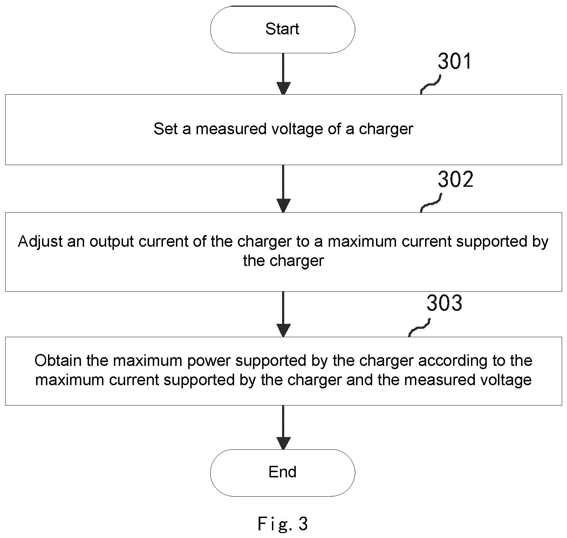

A third embodiment of the invention relates to a charging method, and is roughly the same as the second embodiment. In this embodiment, the process of obtaining a maximum power supported by the charger is described in detail, and is specifically implemented in Fig. 3.

Step 301: a measured voltage of a charger is set.

Specifically, in order to guarantee safety of the charger, a switching charging module is connected in parallel to a charge pump, and the maximum power supported by the charger may be determined by the switching charging module. A measured voltage of the switching charging module is set, and the measured voltage is kept unchanged.

Step 302: an output current of the charger is adjusted to a maximum current supported by the charger.

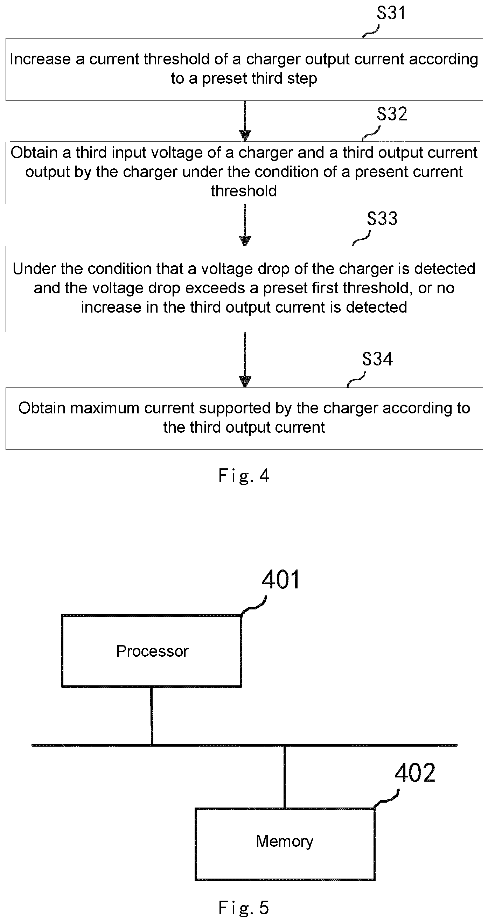

In one example, the process of adjustment may be shown in Fig. 4.

S31: a current threshold of a charger output current is increased according to a preset third step.

Specifically, an initial current threshold of a charger output current is set to Iset, and is requires to guarantee that a low-power charger may run. For example, 18 W may be used as a standard to determine a low-power charger, and a 13.5 W charger is less than 18 W, and is a low-power charger. The current threshold may be set to 1.5 A.

The third step may be set according to actual needs, for example, the third step may be set to 100 mA.

It should be noted that the current threshold of the output current of the charger is used to limit the current flowing into the charging chip and is set by the terminal, for example, the output current threshold of the charger is set on a mobile phone. In addition, the output current of the charger is the same as the input current of the charging chip, so the output current of the charger and the input current of the charging chip may also be called front-end currents, or the output current of the charger and the input current of the charging chip may also be called online currents.

S32: a third input voltage of a charger and a third output current output by the charger are obtained under the condition of a present current threshold.

For example, the current threshold increased last time is denoted as Iset, the third step is denoted as Idelta, a current threshold increased this time is denoted as Iset' = Iset+Idelta, the third input voltage is denoted as Vnow, and the third output current is denoted as Inow.

S33: under the condition that a voltage drop of the charger is detected and the voltage drop exceeds a preset first threshold, or no increase in the third output current is detected, S34 is executed.

In one example, after the current threshold is increased this time, it is determined whether the charger has the voltage drop, if so, the voltage drop is obtained, if not, return to step S31, and the current threshold is increased according to the third step.

The process of obtaining the voltage drop may be as follows: a fourth input voltage of the charger and a fourth output current output by the charger are obtained under the condition of the current threshold increased last time; a second input voltage difference generated by the charger is obtained according to the third input voltage and the fourth input voltage; a second output current difference generated by the charger is obtained according to the third output current and the fourth output current; and the voltage drop is obtained according to the second input voltage difference, the second output current and the equivalent impedance.

Particularly, the current threshold increased last time is denoted as Iset, and in the case of the current threshold Iset, the obtained fourth input voltage of the charger is denoted as Vpre, and the fourth output current output by the charger is denoted as Ipre. The third step is denoted as Idelta, a current threshold increased this time is denoted as Iset' = Iset+Idelta, the third input voltage is denoted as Vnow, and the third output current is denoted as Inow.

The voltage drop Vd may be obtained as shown in formula (4).

$$Vd = Vpre - Vnow - (Inow - Ipre) * R_{line} \qquad (4);$$

where Vpre is the fourth input voltage, Vnow is the third input voltage, Inow is the third output current, Ipre is the fourth output current, and $R_{line}$ is the equivalent impedance.

In another example, the third output current may be compared with the last fourth output current, and if the third output current does not increase, step S34 is executed.

S34: maximum current supported by the charger is obtained according to the third output current.

Specifically, a preset redundancy value is subtracted from the third output current to obtain the maximum current supported by the charger.

Step 303: the maximum power supported by the charger is obtained according to the maximum current supported by the charger and the measured voltage.

Specifically, the product of the maximum current supported by the charger and the measured voltage may be taken as the maximum power supported by the charger.

In another example, different measured voltages may be set, and steps 301-303 may be performed. For example, at 5 V, 9 V and 12 V, maximum powers supported by the charger are obtained respectively. If the obtained maximum powers supported by the charger are different, linear fitting is performed. For example, when the voltage is adjusted between 5 V-9 V, a power supported by a target voltage is computed according to the adjusted target voltage and the powers of 5 V and 9 V, and then the maximum current supported by the charger is computed according to the power. For example, a maximum current and power are 3 A and 15 W at 5 V respectively, and are 2 A and 18 W at 9 V respectively, so a maximum power and a maximum current supported by the charger are 16.5 W and 2.357A at 7 V respectively.

After the maximum current supported by the charger is obtained, the input voltage, the output current and current threshold of the charger are restored.

In addition, those skilled in the art can understand that the step division of the method above is merely for the sake of description clearness, and the steps may be combined into one step or some steps may be split into multiple steps, as long as the same logical relationship is included, all of which are within the protection scope of this patent. Adding insignificant modification or introducing insignificant design to the algorithm or flow, without changing core design thereof shall fall within the protection scope of this patent.

A fourth embodiment of the invention relates to a terminal, as shown in Fig. 5. The terminal includes at least one processor 401; and a memory 402 in communication connection with the at least one processor 401, where the memory 402 stores an instruction executable by the at least one processor 401, and when executed by the at least one processor 401, the instruction causes the at least one processor 401 to execute the charging method above.

The memory and the processor are connected through a bus, and the bus may include interconnected buses and bridges unlimited in the number, and the bus connects various circuits of one or more processors and the memory together. The bus may further connect various other circuits such as peripheral devices, voltage regulators, and power management circuits, which are well known in the art, and therefore are not further described herein. A bus interface provides an interface between the bus and a transceiver. The transceiver may be one or more components, such as a plurality of receivers and senders, providing a unit for being in communication with various other apparatuses on a transmission medium. Data processed by the processor are transmitted on a wireless medium through an antenna. In this embodiment, the antenna also receives the data and transmits the data to the processor.

The processor is responsible for managing the bus and general processing, and may also provide various functions, including timing, peripheral interfaces, voltage regulation, power management and other control functions. The memory may be used for storing data used by the processor during operations.

A fifth embodiment of the invention relates to a computer-readable storage medium storing a computer program. The computer program implements the embodiments of the charging method when executed by a processor. The computer-readable storage media include transient, non-transient, removable and non-removable media implemented in any method or technology for storing information (such as a computer-readable instruction, a data structure, a program module or other data).

That is, it may be understood by those skilled in the art that all or a portion of the steps for implementing the method of the above embodiments may be completed by instructing related hardware through the program, which is stored in the storage medium and includes several instructions to make a device (which may be a single chip microcomputer, a chip, etc.) or a processor perform all or a portion of the steps of the methods described in the embodiments of the invention. The foregoing storage medium includes a USB flash drive, a mobile hard disk drive, a read-only memory (ROM), a random access memory (RAM), a diskette or optical disk, etc., which may store program codes.

It can be understood by those skilled in the art that the above embodiments are particular embodiments to implement the invention, and in a practical application, various changes can be made to the form and details without departing from the spirit and scope of the invention.

**Claims**

1. A charging method, comprising:

    obtaining an equivalent impedance between a charger and a charging chip of a terminal and a battery impedance of a battery in the terminal;
    obtaining a charging power according to the battery impedance, the equivalent impedance and a target power, wherein the target power comprises a maximum power supported by the battery or a maximum power supported by the charger; and
    controlling the charger to charge the battery according to the charging power.

2. The charging method according to claim 1, the obtaining a charging power according to the battery impedance, the equivalent impedance and a target power comprises:

    obtaining a present actual input voltage of the charger and a present battery current flowing into the battery;
    obtaining, according to the actual input voltage, the battery current, the battery impedance and the equivalent impedance, a predicted power after the actual input voltage of the charger is increased next time;
    determining whether the predicted power exceeds the target power, and generating, under the condition that the predicted power exceeds the target power, the charging power according to the actual input voltage and the battery current; and increasing, under the condition that the predicted power does not exceed the target power, the actual input voltage according to a preset first step until the obtained predicted power exceeds the target power.

3. The charging method according to claim 2, wherein the obtaining, according to the input voltage, the battery current, the battery impedance and the equivalent impedance, a predicted power after the actual input voltage of the charger is increased next time comprises:

obtaining, according to the first step, the battery current, the battery impedance and the equivalent impedance, a predicted battery current after the actual input voltage of the charger is increased next time; and

taking a product of the actual input voltage and the predicted battery current as the predicted power.

4. The charging method according to claim 3, wherein before the taking a product of the input voltage and the predicted battery current as the predicted power, the method further comprises:
determining whether the predicted battery current is less than a maximum current supported by the battery, and if so, performing the step of taking a product of the actual input voltage and the predicted battery current as the predicted power.

5. The charging method according to any one of claims 1-4, wherein the obtaining an equivalent impedance between a charger and a charging chip of a terminal comprises:

   obtaining a first output current difference according to a first output current output by the charger at a first moment and a first input voltage of the charger at the first moment;
   obtaining a first input voltage difference according to a second output current output by the charger at a second moment and a second input voltage of the charger at the second moment; and
   obtaining the equivalent impedance according to the ratio between the first input voltage difference and the first output current difference.

6. The charging method according to any one of claims 1-4, wherein the obtaining battery impedance of a battery in the terminal comprises:

   obtaining a measured current flowing into the battery under an initial voltage of the charger; and increasing the initial voltage according to a preset second step to obtain an adjusted measured current;
   obtaining the battery impedance according to the measured current, the adjusted measured current and the equivalent impedance.

7. The charging method according to any one of claims 1-4, wherein before the obtaining a charging power according to the battery impedance, the equivalent impedance and a target power, the method further comprises:

   setting a measured voltage of the charger;
   adjusting an output current of the charger to a maximum current supported by the charger;
   obtaining the maximum power supported by the charger according to the maximum current supported by the charger and the measured voltage.

8. The charging method according to claim 7, wherein the adjusting an output current of the charger to a maximum current supported by the charger comprises:

   increasing a current threshold of the charger output current according to a preset third step;
   obtaining a third input voltage of the charger and a third output current output by the charger under the condition of a present current threshold; and
   obtaining, under the condition that a voltage drop of the charger is detected and the voltage drop exceeds a preset first threshold, or no increase in the third output current is detected, the maximum current supported by the charger according to the third output current.

9. The charging method according to claim 8, wherein the obtaining a voltage drop comprises:

   obtaining a fourth input voltage of the charger and a fourth output current output by the charger under the condition of the current threshold increased last time;
   obtaining a second input voltage difference generated by the charger according to the third input voltage and the fourth input voltage;
   obtaining a second output current difference generated by the charger according to the third output current and the fourth output current; and
   obtaining the voltage drop according to the second input voltage difference, the second output current and the equivalent impedance.

10. A user terminal, comprising:

at least one processor; and,
a memory in communication connection with the at least one processor, wherein
the memory stores an instruction executable by the at least one processor, and when executed by the at least one processor, the instruction causes the at least one processor to execute the charging method according to any one of claims 1-9.

11. A computer-readable storage medium, storing a computer program, wherein the computer program implements the charging method according to any one of claims 1-9 when executed by a processor.

Start

101

Obtain an equivalent impedance between a charger and a charging chip of a terminal and a battery impedance of a battery in the terminal

102

Obtain a charging power according to the battery impedance, the equivalent impedance and a target power

103

Control the charger to charge the battery according to the charging power

End

Fig. 1

Start

201

Obtain an equivalent impedance between a charger and a charging chip of a terminal and a battery impedance of a battery in the terminal

202

Obtain a present actual input voltage of the charger and a present battery current flowing into the battery

203

Obtain, according to the actual input voltage, the battery current, the battery impedance and the equivalent impedance, a predicted power after the actual input voltage of the charger is increased next time

204

Whether the predicted power exceeds a maximum power supported by the battery or a maximum power supported by the charger

NO

Yes

205

Generate a charging power according to the actual input voltage and the battery current

206

Increase the actual input voltage according to a preset first step

207

Control the charger to charge the battery according to the charging power

End

Fig. 2

```
                        ┌──────────────┐
                        │    Start     │
                        └──────┬───────┘
                               │                        301
                               ▼
    ┌──────────────────────────────────────────────────────────────┐
    │          Set a measured voltage of a charger                  │
    └──────────────────────────────┬───────────────────────────────┘
                                    │                        302
                                    ▼
    ┌──────────────────────────────────────────────────────────────┐
    │  Adjust an output current of the charger to a maximum current │
    │            supported by the charger                           │
    └──────────────────────────────┬───────────────────────────────┘
                                    │                        303
                                    ▼
    ┌──────────────────────────────────────────────────────────────┐
    │  Obtain the maximum power supported by the charger according  │
    │  to the maximum current supported by the charger and the      │
    │  measured voltage                                             │
    └──────────────────────────────┬───────────────────────────────┘
                                    │
                                    ▼
                        ┌──────────────┐
                        │     End      │
                        └──────────────┘
```

Fig. 3

S31

Increase a current threshold of a charger output current according to a preset third step

S32

Obtain a third input voltage of a charger and a third output current output by the charger under the condition of a present current threshold

S33

Under the condition that a voltage drop of the charger is detected and the voltage drop exceeds a preset first threshold, or no increase in the third output current is detected

S34

Obtain maximum current supported by the charger according to the third output current

Fig. 4

401

Processor

402

Memory

Fig. 5

## INTERNATIONAL SEARCH REPORT

| | International application No. |
|---|---|
| | **PCT/CN2021/099435** |

**A. CLASSIFICATION OF SUBJECT MATTER**

H02J 7/00(2006.01)i

According to International Patent Classification (IPC) or to both national classification and IPC

**B. FIELDS SEARCHED**

Minimum documentation searched (classification system followed by classification symbols)

H02J

Documentation searched other than minimum documentation to the extent that such documents are included in the fields searched

Electronic data base consulted during the international search (name of data base and, where practicable, search terms used)

WPI, EPODOC, CNPAT, CNKI: 充电, 电池, 阻抗, 内阻, 电阻, 电抗, 等效, 功率, 最大, 预, 测, 估, 电压, 电流, charg+, battery, impedance, power, max, voltage, current

**C. DOCUMENTS CONSIDERED TO BE RELEVANT**

| Category* | Citation of document, with indication, where appropriate, of the relevant passages | Relevant to claim No. |
|---|---|---|
| PX | CN 112350393 A (ZTE CORPORATION) 09 February 2021 (2021-02-09) claims 1-11 | 1-11 |
| X | CN 107196372 A (BEIJING XIAOMI MOBILE SOFTWARE CO., LTD.) 22 September 2017 (2017-09-22) description, paragraphs 97-118, figures 1-12 | 1, 5-7, 10-11 |
| A | CN 106451592 A (BEIJING CHEHEJIA INFORMATION TECHNOLOGY CO., LTD.) 22 February 2017 (2017-02-22) entire document | 1-11 |
| A | CN 109962514 A (VIVO COMMUNICATION TECHNOLOGY CO., LTD.) 02 July 2019 (2019-07-02) entire document | 1-11 |
| A | CN 104113114 A (XIAMEN MEITU MOBILE TECHNOLOGY CO., LTD.) 22 October 2014 (2014-10-22) entire document | 1-11 |
| A | US 2016064979 A1 (MOPHIE, INC.) 03 March 2016 (2016-03-03) entire document | 1-11 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 August 2021** | **27 August 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/099435**

| Patent document cited in search report | | | Publication date (day/month/year) | Patent family member(s) | | | Publication date (day/month/year) |
|---|---|---|---|---|---|---|---|
| CN | 112350393 | A | 09 February 2021 | | None | | |
| CN | 107196372 | A | 22 September 2017 | CN | 107196372 | B | 09 March 2021 |
| CN | 106451592 | A | 22 February 2017 | CN | 106451592 | B | 05 April 2019 |
| CN | 109962514 | A | 02 July 2019 | CN | 109962514 | B | 08 January 2021 |
| CN | 104113114 | A | 22 October 2014 | CN | 104113114 | B | 22 February 2017 |
| US | 2016064979 | A1 | 03 March 2016 | US | 10079496 | B2 | 18 September 2018 |
| | | | | US | 10033204 | B2 | 24 July 2018 |
| | | | | US | 2016064963 | A1 | 03 March 2016 |
| | | | | US | 9997933 | B2 | 12 June 2018 |
| | | | | US | 2016064962 | A1 | 03 March 2016 |

Form PCT/ISA/210 (patent family annex) (January 2015)